Europäisches Patentamt

European Patent Office

Office européen des brevets

(11) Numéro de publication : **0 312 463 B1**

(12) **FASCICULE DE BREVET EUROPEEN**

(45) Date de publication du fascicule du brevet :
01.02.95 Bulletin 95/05

(51) Int. Cl.[6] : **H03H 17/02**

(21) Numéro de dépôt : **88402606.3**

(22) Date de dépôt : **14.10.88**

(54) **Dispositif de filtrage numérique, et radar comportant un tel dispositif.**

(30) Priorité : **16.10.87 FR 8714291**

(43) Date de publication de la demande :
**19.04.89 Bulletin 89/16**

(45) Mention de la délivrance du brevet :
**01.02.95 Bulletin 95/05**

(84) Etats contractants désignés :
**DE FR GB IT NL**

(56) Documents cités :
**DE-A- 3 610 195
NACHRICHTENTECHNISCHE ZEITSCHRIFT
N.T.Z., vol. 27, no. 11, novembre 1974,
pages425-431, Berlin, DE; W. SCHALLER:
"Verwendung der schnellenFouriertransformation in digitalen Filtern"
IEEE TRANSACTIONS ON ACOUSTICS,
SPEECH, AND SIGNAL PROCESSING, vol.
ASSP-24,**

(56) Documents cités :
**no. 2, avril 1976, pages 109-114, IEEE, New
York, US; M.G. BELLANGER et al.:"Digital filtering by polyphase network: application to
sample-rate alterationand filter banks"
IEEE ASSP MAGAZINE, vol. 3, no. 3, juillet
1986, pages 6-11, IEEE, New York,US; M.G.
BELLANGER: "New applications of digital
signal processing incommunications"**

(73) Titulaire : **THOMSON-CSF
173, Boulevard Haussmann
F-75008 Paris (FR)**

(72) Inventeur : **Auvray, Gérard
THOMSON-CSF
SCPI
19, avenue de Messine
F-75008 Paris (FR)**

(74) Mandataire : **Benoit, Monique et al
THOMSON-CSF
SCPI
B.P. 329
50, rue Jean-Pierre Timbaud
F-92402 Courbevoie Cédex (FR)**

EP 0 312 463 B1

## Description

L'invention a principalement pour objet un dispositif de filtrage numérique et radar comportant un tel dispositif.

L'invention concerne principalement un dispositif de filtrage numérique comportant une pluralité de canaux de traitement parallèle.

Il est connu d'effectuer des filtrages analogiques utilisant une pluralité de canaux parallèles. Notamment, on utilise une pluralité de canaux de traitement parallèle pour réaliser, en analogique, la compression d'impulsions radar. Si N est le nombre de canaux utilisés. Le taux de compression de chaque canal sera égal à $\mu/N^2$ si $\mu$ est le taux de compression.

De même, en numérique il serait avantageux de partager le traitement à effectuer entre N canaux parallèles de cadence de traitement N fois plus lente. Le taux de compression à effectuer par chaque canal serait égal à $BT/N^2$, où B est la bande passante du signal et T la largeur d'impulsion. Le taux de compression du dispositif, comportant les N canaux placés en parallèle est égal à BxT.

Antérieurement à la mise au point du dispositif selon la présente invention, on croyait que dans les cas de travail dans N canaux parallèles il était nécessaire d'effectuer le filtrage numérique de chaque canal en glissant, d'effectuer sur ces données le filtrage de chaque canal et de sommer les résultats. Ce qui conduit à une puissance de calcul nécessaire proportionnelle à $N^2$.

Dans un article de W. Schaller "Verwendug der schnellen Fourier transformation in digitalen Filtern" paru dans Nachrichtentechnische Zeitschrift, vol. 27, N° 11, novembre 1974, pages 425-431, est décrite l'utilisation de la transformée de Fourier rapide dans les filtres numériques. On peut ainsi remplacer une opération compliquée de convolution dans le temps par une opération bien plus simple de multiplication dans le domaine des fréquences. Cependant toutes les opérations s'effectuent à la cadence de la fréquence d'échantillonnage du signal d'entrée, la fréquence maximum du signal d'entrée qu'on peut traiter étant ainsi limitée par les performances en fréquence des circuits de traitement de chaque canal.

Dans un article de M.G. Bellanger "New application of digital signal processing" paru dans IEEE ASSP Magazine vol. 3, N° 3, juillet 1986, pages 6-11, il est proposé de réduire la cadence de traitement dans des voies de traitement parallèles entre un dispositif de transformée de Fourier discrète et un dispositif de transformée de Fourier inverse. Mais pour obtenir cela, il est nécessaire de compléter les transformée de Fourier et transformée de Fourier inverse par des filtres polyphases à N voies qui ajoutent à la complexité du filtrage numérique.

L'invention a pour but de remédier à ces divers inconvénients en prévoyant un système très simple qui permette à la fois de réduire les puissances de calcul nécessaires en effectuant la séparation du traitement en canaux par une transformée de Fourier discrète sur 2N-1 points et de diviser la cadence de traitement par N pour augmenter notablement les performances en fréquence du filtre obtenu.

L'invention a donc pour objet un dispositif de filtrage numérique utilisant la transformée de Fourier, tel que défini dans les revendications.

L'invention sera mieux comprise au moyen de la description ci-après et des figures annexées parmi lesquelles :
- la figure 1 est une courbe d'une fonction en fonction du temps ;
- la figure 2 est la représentation de la courbe de la figure 1 échantillonnée ;
- la figure 3 est le schéma d'une partie des échantillons de la figure 2 rendu périodique ;
- la figure 4 illustre le calcul de la transformée de Fourier glissante de type connu ;
- la figure 5 illustre un premier exemple de réalisation de calcul de la transformée de Fourier susceptibles d'être mis en oeuvre dans la présente invention ;
- la figure 6 illustre un second exemple de réalisation de calcul de la transformée de Fourier susceptibles d'être mis en oeuvre dans la présente invention ;
- la figure 7 est un schéma d'un filtrage transverse susceptible d'être utilisé dans le dispositif selon la présente invention ;
- la figure 8 est un schéma d'un filtre numérique utilisant des canaux parallèles ;
- la figure 9 est un schéma d'un exemple de réalisation du dispositif selon la présente invention ;
- la figure 10 est un schéma d'un exemple de réalisation du dispositif selon la présente invention ;
- la figure 11 est un schéma d'un exemple de réalisation du dispositif selon la présente invention ;
- la figure 12 est un schéma d'un exemple de réalisation du dispositif selon la présente invention ;
- la figure 13 est un schéma d'un exemple de réalisation du dispositif selon la présente invention.

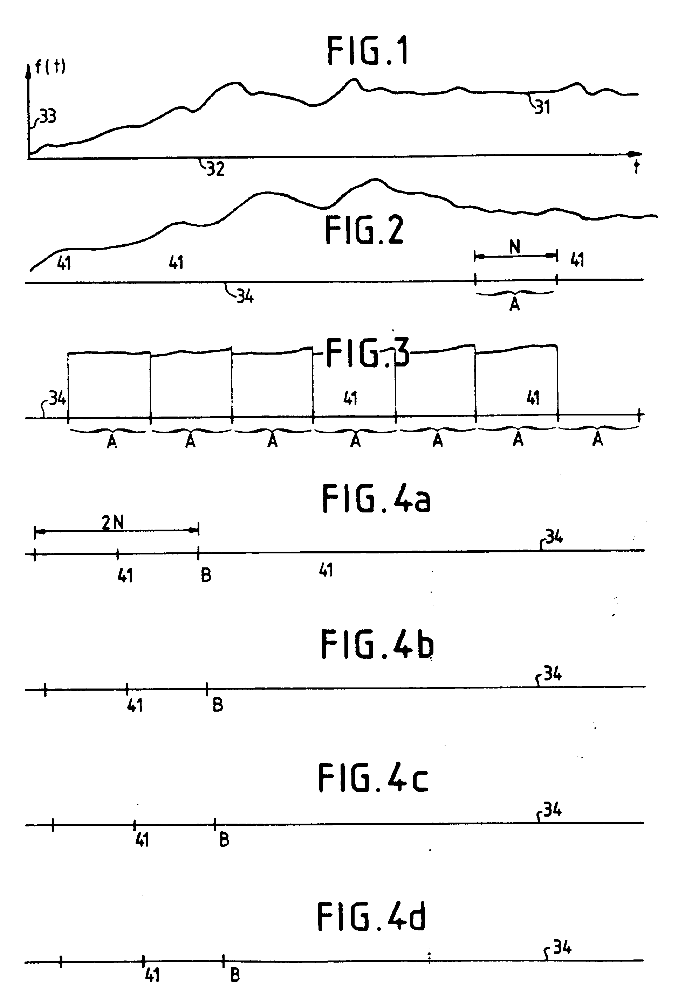

Sur la figure 1, on peut voir la courbe 31 d'une fonction f 33 en fonction du temps 32. La courbe 31 correspond par exemple à la modulation d'un signal électrique. Si l'on désire effectuer un traitement numérique du signal, on procède, comme illustré sur la figure 2, à un échantillonnage du signal.

EP 0 312 463 B1

Sur la figure 2, on peut voir sur un axe 34, correspondant au temps 32 de la figure 1 les valeurs numériques 41 de la fonction f au temps t. Si l'on faisait tendre vers l'infini la fréquence d'échantillonnage du signal, en faisant tendre vers zéro la distance temporelle entre deux échantillons 41 successifs, on aurait dans le signal numérisé présente toute l'information contenue dans le signal analogique de départ. En pratique, on prend une fréquence d'échantillonnage conforme au théorème de SHANON étant bien entendu que toute augmentation de la fréquence d'échantillonnage nécessite l'utilisation des matériels plus performants.

Soit A un intervalle de temps comportant N échantillons 41. Le calcul de la transformée de Fourier rapide sur N points de l'intervalle A ne correspondent pas au calcul de la fonction numérisée de la figure 2 mais à une fonction rendue périodique illustrée sur la figure 3.

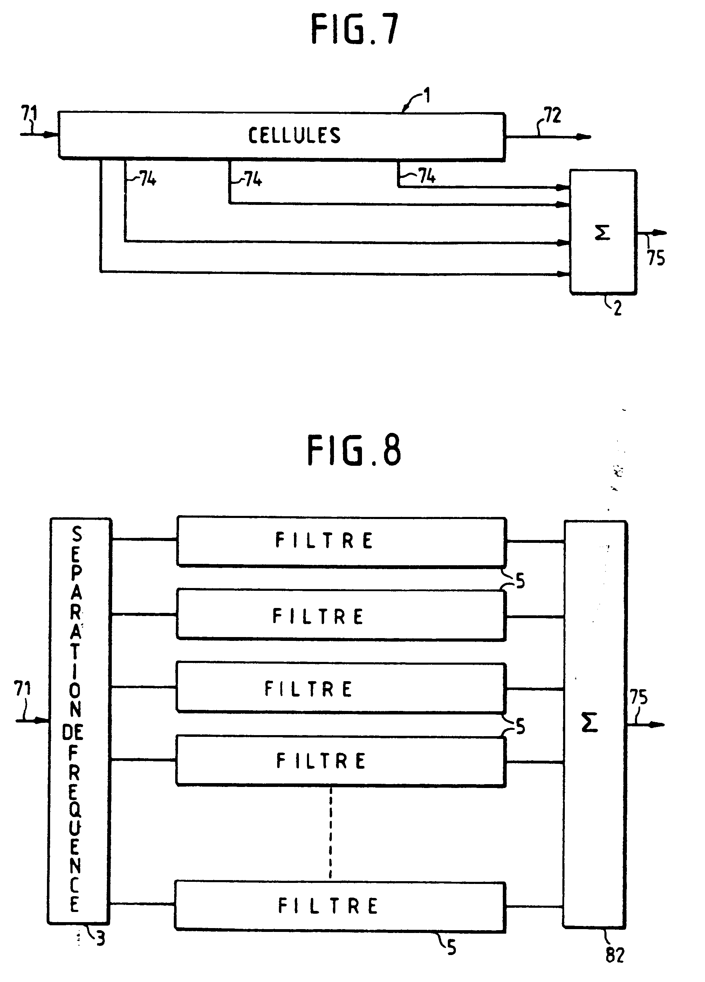

Sur la figure 3 on peut voir une fonction périodique comportant une succession d'intervalles A de N échantillons 41. Dans les dispositifs de filtrage à canaux parallèles de type connu, comme par exemple les dispositifs illustrés sur la figure 8, on effectue une transformée de Fourier glissante illustrée sur la figure 4, correspondant à une transformée de Fourier sur $N^2$ points.

Un cycle de calculs sépare les figures 4a, 4b, 4c et 4d. A chaque cycle de calculs on calcule une transformée de Fourier sur 2N points 41 en déplaçant, à chaque cycle de calcul l'intervalle de calcul B d'un échantillon.

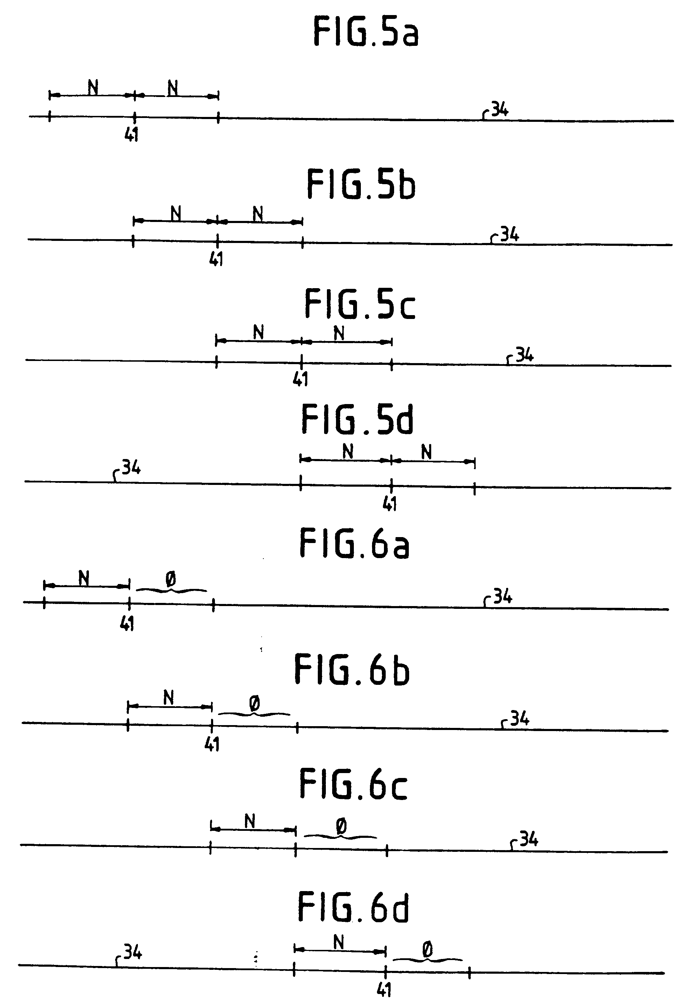

Sur la figure 5, on peut voir un premier exemple de calcul de la transformée de Fourier mis en oeuvre dans le dispositif selon la présente invention. Un cycle de calculs sépare les figures 5a, 5b, 5c et 5d. Seuls les quatre premiers cycles de calcul on été illustrés. Il est bien entendu que le processus se poursuit jusqu'à la fin du calcul à effectuer.

Sur la figure 5a, on effectue un calcul de la transformée de Fourier rapide sur 2N points 41. Sur la figure 5b, au cycle de calcul suivant, on effectue le calcul sur 2N points 41 décalés de N par rapport aux points de la figure 5a. De même, sur la figure 5c un cycle de calcul après la figure 5b, on effectue le calcul de la transformée de Fourier rapide sur 2N points 41 décalés de N par rapport au début de l'intervalle de la figure 5b. De façon générale, à chaque cycle de calcul on effectue le calcul de la transformée rapide sur un intervalle contenant 2N points 41 l'intervalle étant décalé de N points par rapport au cycle de calcul précédent.

Sur la figure 6, on peut voir le second exemple de calcul mis en oeuvre dans le dispositif selon la présente invention. Les figures 6a, 6b, 6c et 6d sont décalées d'un cycle de calcul. Au temps correspondant à la figure 6a on effectue le calcul de la transformée de Fourier rapide sur un intervalle comportant N points 41 correspondant aux échantillons du signal à traiter suivis par N ∅.

Sur la figure 6b on effectue les calculs sur les N points 41 suivants suivis par N ∅. A chaque cycle de calcul on effectue le calcul de transformée de Fourier rapide sur un intervalle comportant N points 41 suivis par N ∅. Entre deux cycles de calcul l'intervalle est décalé de N points.

Sur la figure 7, on peut voir un exemple de filtre susceptible d'être mis en oeuvre dans le dispositif selon la présente invention. Il s'agit d'un filtre transverse, connu en soi. Un tel filtre comporte une pluralité d'étages connectés les uns aux autres. Le signal se propage entre une entrée 71 et une sortie 72 de la pluralité d'étages 1. Le filtre comporte une pluralité de sorties 74 transverse. Les sorties 74 sont reliées à chacun à des étages du filtre dans lequel on a effectué la multiplication du signal par un coefficient de pondération. Les sorties 74 sont connectées à l'entrée d'un dispositif de sommation 2. Le résultat des calculs est disponible sur la sortie 75 du dispositif de sommation 2.

La sortie 72 de la pluralité d'étages 1 est susceptible d'être connectée à l'entrée d'un filtre transverse suivant mis en série (non représenté sur la figure 7). Le filtre transverse global sortant alors un signal en sommant les deux sorties 75.

Le cas de compression d'impulsion correspond à des valeurs particulières des coefficients de multiplication des sorties 74, le signal utile se trouve sur la sortie 75.

Sur la figure 8, on peut voir un dispositif de filtrage de type connu équivalent au filtre transverse de la figure 7. Le dispositif de filtrage de la figure 8 comporte un dispositif 3 de filtrage numérique en glissant fournissant les signaux relatifs aux N canaux parallèles. Le dispositif 3 répartit les sous bandes de fréquence entre les filtres 5 placés en parallèle. Le dispositif de calcul de la figure 8 effectue un calcul glissant, c'est-à-dire qu'à chaque cycle de calcul un nouvel échantillon entre dans les filtres 5. Il en résulte que la puissance de calcul global du dispositif de la figure 8 est proportionnelle à $N^2$, N étant le nombre de filtres 5. La sortie du dispositif de calcul 3 est connectée en parallèle à une pluralité de filtres 5. Les filtres 5 se répartissent la bande passante du signal à traiter. Les filtres 5 sont des filtres numériques de type connu. Les sorties des filtres 5 sont connectées à un dispositif 4 de sommation. A la sortie du dispositif de calcul 4 on dispose du signal filtré. Le dispositif de la figure 8 nécessite la mise en oeuvre du dispositif de calcul de filtrage numérique ayant de très grandes capacités de calcul.

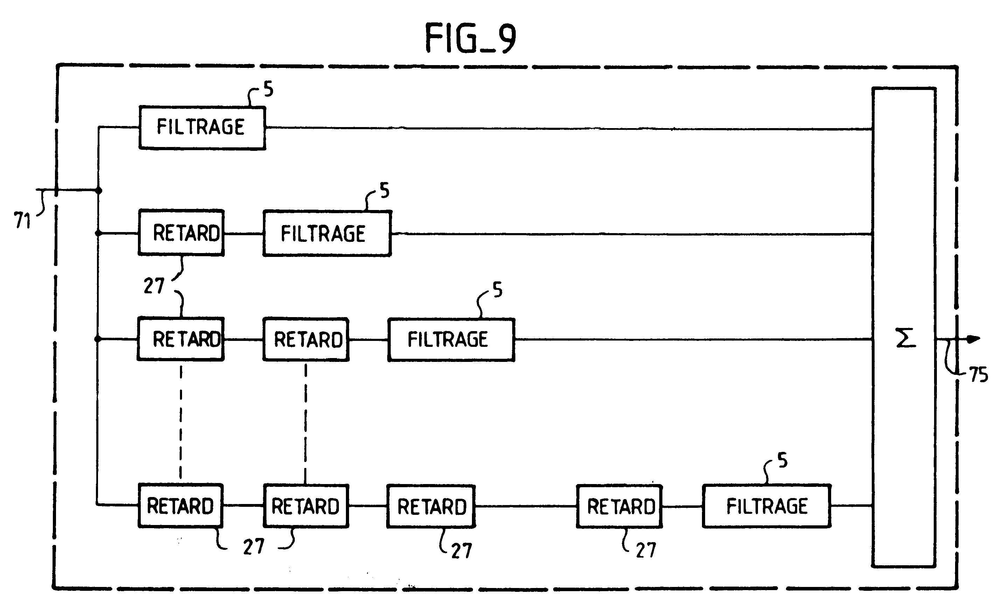

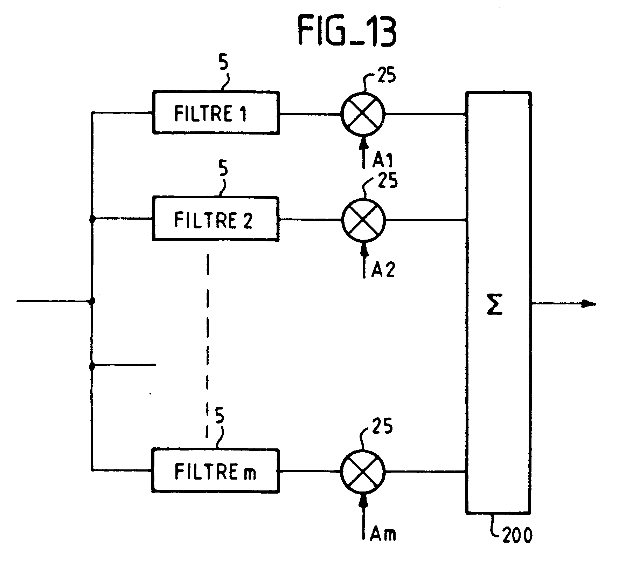

Sur la figure 9 nous pouvons voir un schéma équivalent au filtre transverse de la figure 7. Le filtre de la figure 13 comporte des voies parallèles. Chaque voie comporte un élément de filtrage correspond à un tronçon

3

de cellules du filtre transverse et entre 0 et $\ell$ -1 éléments induisant un incrément de retard de $\ell\tau$ ; $\ell$ étant le nombre de voies.

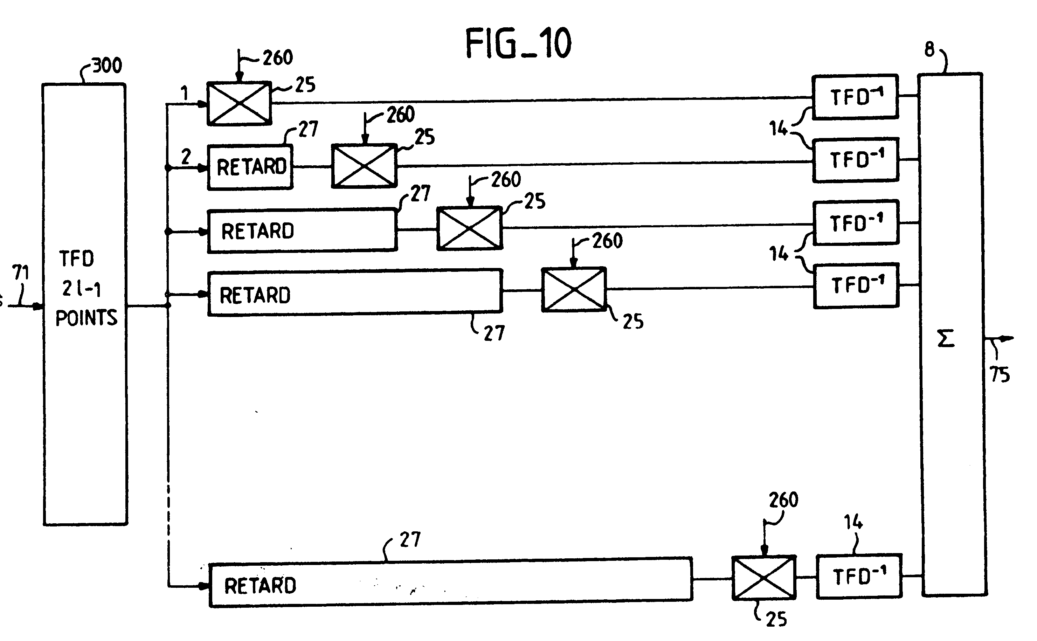

Sur la figure 10 on peut voir une réalisation équivalente de la figure 9 où la réponse de chaque filtre correspondant à chacune des voies est calculé par TFD (TFD)$^{-1}$ portant sur $2\ell$-1 points. Chacun des canaux 1.2... $\ell$ comporte comporte $2\ell$-1voies correspondant aux $2\ell$-1 coefficient TFD du signal d'entrée 71.

Le dispositif de la figure 10 peut effectuer une fonction de filtrage transerve N points. Les calculs sont effectués par chacun des m canaux parallèles, chaque canal traitant 1 point. Donc N=m.1.

Dans ce qui suit, les indices supérieurs représentent le numéro du canal (1 à m), les indices inférieurs le numéro de l'échantillon.

Avantageusement, les coefficients 260 sont :

$A^1_i$, $A^m_i$ avec i = 1 à $2\ell$ -1

les coefficients de la TFD de la réponse impulsionnelle des filtres transverses 1 à m de la figure 9.

Les signaux numériques 720 fournis à la sortie du filtre sont :

$$z_{nr} = \sum_{p=1}^{m} y^P_{nr}$$

r étant le numéro du bloc de point de la TFD

$$y^P_{nr} = \sum_{i=0}^{i=2\ell-2} F_{ir-(p-1)\ell}\, A^P_i\ \exp\,(j2\pi\, ni/2\ell\text{-}1)$$

les y étant les signaux présents à la sortie des filtres 25 ;
les F étant les TFD de la fonction f à filtrer.
donc :

$$z_{nr} = \sum_{i=0}^{i=2\ell-2} \exp\,(j2\pi ni/2\ell\text{-}1)\Big[\sum_{p=1}^{p=m} F_{ir-(p-1)\ell}\, A^P_i\ \Big]$$

C'est la (TFD)$^{-1}$ d'un ensemble de raies DFT F'i correspondant au terme entre crochet.

$$F'_i = \sum_{p=1}^{p=m} F_{ir-(p-1)\ell}\, A^P_i$$

F' est la convolution linéaire des $F_i$ des blocs successifs avec la réponse impulsionnelle d'un filtre constitué par $A^{pi}$ avec p = 1 à m.

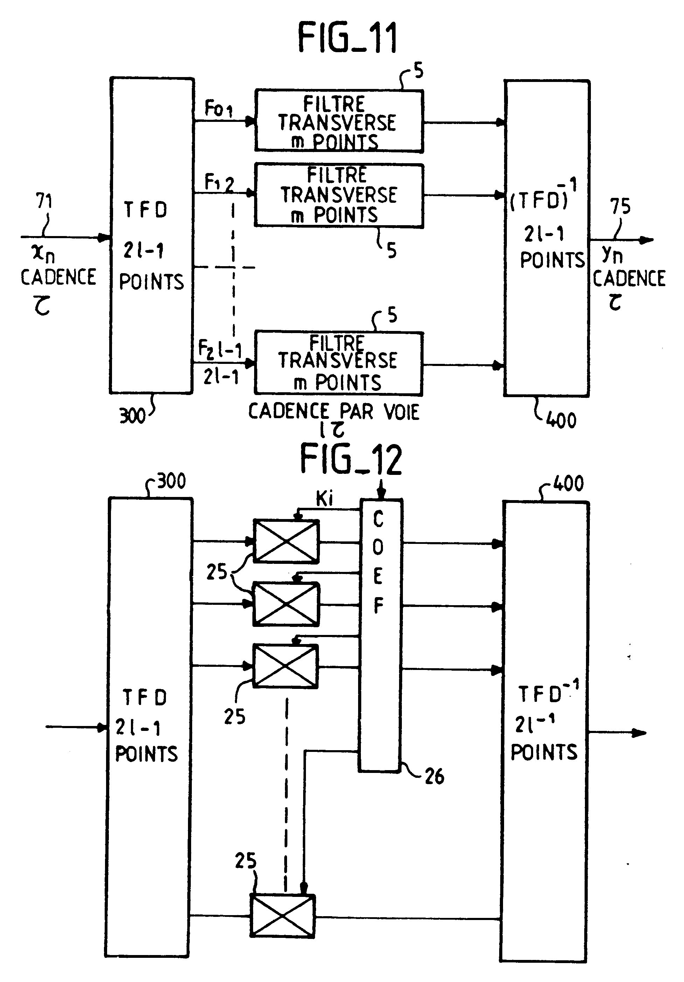

On en déduit la réalisation décrite par la figure 11 du filtrage suivant la présente invention.

Le dispositif de la figure 11 comprend un dispositif 300 de calcul de TFD sur $2\ell$-1 point connecté en parallèle à un ensemble de canaux comportant des filtres transperse 5. Les sorties des filtres transperses 5 sont connectées aux entrées d'un dispositif de calcul de TFD inverse 400.

Le signal d'entrée 71 a une candence $\tau$ .

Les filtres transverses 5 fonctionnent à une cadence $\tau$ .

Le signal de sortie 75 est disponible à une candence $\tau$ .

On peut avantageusement remplacer le nombre de point des TFD, (TFD)$^{-1}$ici égal à $2\ell$ -1 par une valeur $2\ell$ puissance de 2 de façon à pouvoir utiliser un dispositif de calcul de transformée de Fourier rapide.

La cadence de calcul du dispositif correspondant à la bande passante du signal numérisé que l'on doit pouvoir traiter est B = $1/\tau$ $\ell\tau$ étant l'incrément de retard des lignes à retard 27 c'est-à-dire la différence de retard induits dans deux canaux parallèles successifs.

La cadence de fonctionnement des filtres transverses est b avec b petit par rapport à B.

Il faut que :

$$\frac{1}{\ell\tau} = b$$

La puissance de calcul nécessaire est donc :

$$m (2\ell - 1) b \simeq 2Nb$$

La puissance de calcul est donc proportionnelle à N dans le cas du dispositif selon la présente invention.

Par contre, dans le cas des dispositifs de l'art antérieur la puissance de calcul nécessaire est égale àN.B = Nαb avec α = B/b.α est le coefficient d'accroissement de la bande.

Dans le cas des dispositifs d'art antérieur la puissance de calcul nécessaire est proportionnelle à αN et non à N. Il est nécessaire d'exclure deux cas extrêmement connus de la portée de l'invention :

le cas où $\ell$ = 1 c'est-à-dire m = N correspond à un filtrage transverse de type connu à une seule voie ;

le cas où m = 1 c'est-à-dire $\ell$ = N correspond à un filtrage classique par TFD et TFD inverse.

Donc dans le cas de la présente invention $\ell$ ε] 1, N [ ∩ Z N étant le nombre de points traité par le filtre selon la présente invention et Z l'ensemble des entiers.

Sur la figure 12, on peut voir un exemple de réalisation du dispositif selon la présente invention ne comportant pas de filtres transverses mais des multiplieurs dans chaque voie. Celui-ci réalise la fonction séparation en sous bandes du signal d'entrée et somme pondérée des sous bandes comme le montre la figure 13.

Le dispositif de la figure 12 comporte un dispositif 300 de calcul de la TFD sur au moins $2\ell - 1$ points connectés à un ensemble de canaux parallèles. Chaque canal parallèle comprend un multiplicateur 25. Les sorties des multiplicateurs sont connectées à un dispositif de calcul de la TFD inverse 400 sur au moins $2\ell - 1$ points.

Les multiplicateurs 25 sont susceptibles de recevoir les coefficients $K_i$ i = 1 à m, par exemple à partir d'une mémoire 26. La mémoire 26, dans un premier exemple de réalisation reçoit les coefficients en série et les émet en parallèle vers les multiplicateurs 25.

Dans un second exemple de réalisation les coefficients sont stockés dans des mémoires et adressés par les séquenceurs non représentés pour fournir le coefficient nécessaire au fonctionnement du dispositif selon la présente invention.

Avantageusement :

$$K_i = F_{ir} \left[ \sum_{p=n}^{p=\ell} \alpha_p \, A^p_i \right]$$

où :

r est le numéro du bloc des points de TFD ;

F est la TFD de la fonction à traiter ;

$\alpha$ p sont les coefficients de la combinaison linéaire.

$A^p_i$ sont les coefficients de la transformée de Fourier des réponses impressionnelles du filtre des canaux parallèles de la figure 13.

Les résultats du calcul sont donc :

$$z_{nr} = \sum_{i=0}^{i=2\ell-1} \exp(j2\pi ni/N) \, K_i$$

La cadence de calcul à l'entrée et à la sortie du dispositif de la figure 12 est égal à $\tau$ tandis qu'à l'intérieur du dispositif selon l'invention la cadence est égale à $\ell\tau$.

Comme précédemment, pour pouvoir utiliser la FFT on pourra prendre $2\ell$ puissance de 2 au lieu de $2\ell - 1$.

Dans le cas où l'on utilise la FFT et que les filtres partageant la bande correspondent à des filtres FFT $\ell$ points. La transformée de Fourier des réponses impulsionnelles de chaque filtre ne comporte qu'une raie correspondant à la fréquence centrale du filtre.

L'opération de combinaison linéaire après séparation en canaux peut donc s'effectuer par FFT. Combinaison linéaire des raies, $(FFT)^{-1}$.

Il n'y a qu'une raie par filtre.

$$A^p_i = 0 \text{ si } i \neq p - 1 \; A^b_{p-1} = a.$$

On utilise donc que les raies de la FFT 2$\ell$ du signal communes avec la FFT$\ell$.

Dans ce cas particulier les FFT ; (FFT)$^{-1}$ sont donc de rang égal au nombre de canaux.

Le dispositif selon la présente invention sera susceptible d'être mis en oeuvre notamment dans des radars, sonars, des dispositifs de télécommunications, des dispositifs de traitement du son ou des images.

## Revendications

1. Dispositif de filtrage numérique utilisant la transformée de Fourier pour filtrer des données d'entrée échantillonnées comportant des échantillons à une cadence prédéterminée arrangés en blocs successifs de $\ell$ échantillons, ledit dispositif incluant des moyens (300) de calcul de la transformée de Fourier discrète sur des ensembles d'échantillons, des moyens (25, 27 ; 5 ; 25, 26) de traitement de données incluant des voies de filtrage parallèles et connectés auxdits moyens de calcul et des troisièmes moyens (14, 8 ; 400) incluant des moyens de calcul de transformée de Fourier inverse (14 ; 400), pour combiner les signaux traités dans lesdites voies et délivrer des données filtrées à ladite cadence prédéterminée, ledit dispositif étant caractérisé en ce que lesdits ensembles, comportant 2$\ell$-1 échantillons d'entrée appliqués auxdits moyens (300) de calcul de la transformée de Fourier discrète, sont décalés, l'un par rapport au suivant, de $\ell$ échantillons et en ce que la cadence de traitement desdites voies parallèles est $\ell$ fois plus forte ($\ell\tau$) que ladite cadence prédéterminée ($\tau$).

2. Dispositif selon la revendication 1, caractérisé en ce que lesdits moyens de traitement de données comprennent :
   - $\underline{m}$ canaux connectés en parallèle auxdits moyens (300) de calcul de la transformée de Fourier discrète par l'intermédiaire de m-1 circuits à retards (27) introduisant un retard constant, égal à $\ell$ fois la période de ladite cadence prédéterminée, entre chaque canal et le canal précédent ; et
   - des moyens (25) de filtrage disposés dans chaque canal pour effectuer une convolution linéaire par multiplication des 2$\ell$-1 points de la transformée de Fourier discrète avec les transformées de Fourier discrètes (260) des réponses impulsionnelles respectivement de $\underline{m}$ sections de filtres transverses ; et en ce que lesdits troisièmes moyens comprennent $\underline{m}$ circuits (14) de calcul de transformée de Fourier discrète inverse disposés aux sorties respectivement desdits $\underline{m}$ canaux et des moyens sommateurs (8) faisant la somme des signaux de sortie desdits circuits de calcul (14).

3. Dispositif selon la revendication 1, caractérisé en ce que lesdits moyens de traitement de données comprennent 2$\ell$-1 voies de filtrage parallèles connectées auxdits moyens (300) de calcul de la transformée de Fourier discrète pour traiter respectivement les 2$\ell$-1 points de ladite transformée de Fourier discrète, et en ce que lesdits troisièmes moyens comprennent un circuit (400) de calcul de la transformée de Fourier inverse à 2$\ell$-1 points des signaux de sortie desdites 2$\ell$-1 voies de filtrage.

4. Dispositif selon la revendication 3, caractérisé en ce que chacune desdites voies de filtrage comporte un filtre transverse (5) à $\underline{m}$ points opérant à une cadence $\ell$ fois plus forte ($\ell\tau$) que ladite cadence prédéterminée ($\tau$).

5. Dispositif selon la revendication 3, caractérisé en ce que chacune desdites voies de filtrage comprend au moins un multiplieur (25) et en ce que lesdits moyens de traitement de données comprennent en outre une mémoire (26) pour stocker des coefficients ($K_i$) et les envoyer en parallèle aux secondes entrées des multiplieurs (25).

6. Dispositif selon l'une quelconque des revendications 1 à 5, caractérisé en ce que chacun desdits ensembles d'échantillons comprend un bloc de $\ell$ échantillons d'entrée suivi d'un bloc de $\ell$ zéros.

## Claims

1. Digital filtering device using the Fourier transform to filter sampled input data containing samples at a predetermined rate arranged in successive blocks of I samples, the said device including means (300) for computing the discrete Fourier transform on sample sets, data processing means (25, 27; 5; 25, 26) which include parallel filtering paths and are connected to the said computing means and third means (14, 8; 400) including inverse Fourier transform computing means (14; 400), for combining the signals processed in the said paths and delivering filtered data at the said predetermined rate, the said device being characterized in that the said sets, containing 2l-1 input samples applied to the said means (300) for computing the discrete Fourier transform, are shifted, one with respect to the next, by l samples and in that the processing rate of the said parallel paths is l times greater (lτ) than the said predetermined rate (τ).

2. Device according to Claim 1, characterized in that the said data processing means comprise:
   - $\underline{m}$ channels connected in parallel to the said means (300) for computing the discrete Fourier transform by way of m-1 delay circuits (27) introducing a constant delay, equal to l times the period of the said predetermined rate, between each channel and the preceding channel; and
   - filtering means (25) placed in each channel in order to perform a linear convolution by multiplying the 2l-1 points of the discrete Fourier transform by the discrete Fourier transforms (260) of the impulse responses of $\underline{m}$ transverse filter sections respectively;
   and in that the said third means comprise $\underline{m}$ inverse discrete Fourier transform computing circuits (14) placed at the outputs of the said $\underline{m}$ channels respectively and summing means (8) forming the sum of the output signals from the said computing circuits (14).

3. Device according to Claim 1, characterized in that the said data processing means comprise 2l-1 parallel filtering paths connected to the said means (300) for computing the discrete Fourier transform in order respectively to process the 2l-1 points of the said discrete Fourier transform, and in that the said third means comprise a circuit (400) for computing the 2l-1 point inverse Fourier transform of the output signals from the said 2l-1 filtering paths.

4. Device according to Claim 3, characterized in that each of the said filtering paths contains a transverse filter (5) with $\underline{m}$ points operating at a rate l times greater (lτ) than the said predetermined rate (τ).

5. Device according to Claim 3, characterized in that each of the said filtering paths comprises at least one multiplier (25) and in that the said data processing means furthermore comprise a memory (26) for storing coefficients ($K_l$) and sending them in parallel to the second inputs of the multipliers (25).

6. Device according to any one of Claims 1 to 5, characterized in that each of the said sample sets comprises a block of l input samples followed by a block of l zeros.


**Patentansprüche**

1. Digitale Filtervorrichtung, die die Fourier-Transformation verwendet, um abgetastete Eingangsdaten zu filtern, die ihrerseits Abtastwerte mit einem vorgegebenen Takt, die in aufeinanderfolgenden Blöcken von $\ell$ Abtastwerten angeordnet sind, enthalten, wobei die Vorrichtung Mittel (300) zum Berechnen der diskreten Fourier-Transformierten für Abtastwert-Gruppen, Mittel (25, 27; 5; 25, 26) zum Verarbeiten von Daten, die ihrerseits parallele und an die Rechenmittel angeschlossene Filterungswege umfassen, sowie dritte Mittel (14, 8; 400) enthält, die Mittel zum Berechnen der inversen Fourier-Transformierten (14; 400) enthalten, um die in den Wegen verarbeiteten Signale zu kombinieren und die gefilterten Daten mit dem vorgegebenen Takt auszugeben, wobei die Vorrichtung dadurch gekennzeichnet ist, daß die Gruppen, die $2\ell$-1 in die Mittel (300) zum Berechnen der diskreten Fourier-Transformierten eingegebene Eingangs-Abtastwerte enthalten, von einer zur nächsten um $\ell$ Abtastwerte verschoben sind und daß der Verarbeitungstakt der parallelen Wege $\ell$ mal höher (lτ) als der vorgegebene Takt (τ) ist.

2. Vorrichtung nach Anspruch 1, dadurch gekennzeichnet, daß die Mittel zum Verarbeiten von Daten enthalten:
   - $\underline{m}$ Kanäle, die an die Mittel (300) zum Berechnen der diskreten Fourier-Transformierten über m-1 Verzögerungsschaltungen (27) parallel angeschlossen sind, wobei die Verzögerungsschaltungen zwischen jedem Kanal und dem vorangehenden Kanal eine konstante Verzögerung einführen, die gleich der $\ell$fachen Periode des vorgegebenen Takts ist; und
   - Filterungsmittel (25), die in jedem Kanal angeordnet sind, um durch Multiplikation der $2\ell$-1 Punkte der diskreten Fourier-Transformierten mit den diskreten Fourier-Transformierten (260) der Impulsantworten von $\underline{m}$ entsprechenden Abschnitten von Transversalfiltern eine lineare Faltung auszuführen;
   und daß die dritten Mittel $\underline{m}$ Schaltungen (14) zum Berechnen der inversen diskreten Fourier-Transformierten, die an den jeweiligen Ausgängen der $\underline{m}$ Kanäle angeordnet sind, sowie Summationsmittel (8) enthalten, die die Summe der Ausgangssignale der Rechenschaltungen (14) bilden.

3. Vorrichtung nach Anspruch 1, dadurch gekennzeichnet, daß die Mittel zum Verarbeiten von Daten $2\ell$-1 parallele Filterungswege enthalten, die an die Mittel (300) zum Berechnen der diskreten Fourier-Transformierten angeschlossen sind, um entsprechend die $2\ell$-1 Punkte der Fourier-Transformierten zu verarbeiten, und daß die dritten Mittel eine Schaltung (400) zum Berechnen der inversen Fourier-Transformierten mit $2\ell$-1 Punkten der Ausgangssignale der $2\ell$-1 Filterungswege enthalten.

4. Vorrichtung nach Anspruch 3, dadurch gekennzeichnet, daß jeder der Filterungswege ein Transversalfilter (5) mit $\underline{m}$ Punkten enthält, das mit einem Takt arbeitet, der $\ell$ mal höher ($\ell\tau$) als der vorgegebene Takt ($\tau$) ist.

5. Vorrichtung nach Anspruch 3, dadurch gekennzeichnet, daß jeder der Filterungswege wenigstens einen Multiplizierer (25) enthält und daß die Mittel zum Verarbeiten von Daten außerdem einen Speicher (26) enthalten, um Koeffizienten ($K_l$) zu speichern und sie parallel an die zweiten Eingänge der Multiplizierer (25) zu schicken.

6. Vorrichtung nach irgendeinem der Ansprüche 1 bis 5, dadurch gekennzeichnet, daß jede der Abtastwert-Gruppen einen Block von $\ell$ Eingangs-Abtastwerten, gefolgt von einem Block von $\ell$ Nullen, enthält.

# FIG.1

$f(t)$

33

32

31

t

# FIG.2

41        41                                    N          41

34                                              A

# FIG.3

34

41                    41

A      A      A      A      A      A      A

# FIG.4a

2N

34

41          B          41

# FIG.4b

34

41          B

# FIG.4c

34

41          B

# FIG.4d

34

41          B

# FIG.5a

# FIG.5b

# FIG.5c

# FIG.5d

# FIG.6a

# FIG.6b

# FIG.6c

# FIG.6d

# FIG.7

# FIG.8

# FIG_9

71

12

EP 0 312 463 B1

75

FIG_10

Σ

TFD⁻¹ 14

TFD⁻¹

TFD⁻¹

TFD⁻¹ 14

TFD⁻¹ 14

8

75

260 25

RETARD 27

260 25

260 25

260 25

260 25

RETARD 27

RETARD 27

RETARD 27

RETARD 27

1

2

TFD
2ᴸ⁻¹
POINTS

300

71

13

# FIG_11

TFD
$2l-1$
POINTS

$71$
$x_n$
CADENCE
$\tau$

$300$

$F_{0\,1}$

$F_{1\,2}$

$F_{2\,l-1}$
$2l-1$

FILTRE
TRANSVERSE
m POINTS

$5$

FILTRE
TRANSVERSE
m POINTS

$5$

FILTRE
TRANSVERSE
m POINTS

$5$

CADENCE PAR VOIE
$\dfrac{\tau}{2l}$

$(TFD)^{-1}$
$2l-1$
POINTS

$75$
$y_n$
CADENCE
$\tau$

$400$

# FIG_12

$300$

TFD
$2l-1$
POINTS

$25$

$25$

$25$

$K_i$

C
O
E
F

$26$

$400$

TFD$^{-1}$
$2l-1$
POINTS

FIG_13